# EUROPÄISCHE PATENTSCHRIFT

(11) **EP 2 834 593 B1**
(45) Veröffentlichungstag und Bekanntmachung des Hinweises auf die Patenterteilung: **31.07.2019**
(21) Anmeldenummer: 13713449.0
(22) Anmeldetag: 02.04.2013
(51) Int. Cl.: G01B 11/14

(54) **VERFAHREN UND VORRICHTUNG ZUR ABSTANDSMESSUNG MIT EINER DIFFRAKTIVEN STRUKTUR**
METHOD AND DEVICE FOR MEASURING DISTANCE USING A DIFFRACTIVE STRUCTURE
PROCÉDÉ ET DISPOSITIF DE MESURE DE DISTANCE AU MOYEN D'UNE STRUCTURE DIFFRACTIVE

(30) Priorität: 05.04.2012 DE 102012103008
(43) Veröffentlichungstag der Anmeldung: 11.02.2015
(73) Patentinhaber: Fraunhofer Gesellschaft zur Förderung der angewandten Forschung e.V., 80686 München (DE)
(72) Erfinder: HARZENDORF, Torsten, 07745 Jena (DE); STÜRZEBECHER, Lorenz, 07745 Jena (DE); ZEITNER, Uwe D., 99423 Weimar (DE); VOGLER, Uwe, CH-2000 Neuchatel (CH); VÖLKEL, Reinhard, CH-2000 Neuchatel (CH)
(74) Vertreter: Epping - Hermann - Fischer
(86) Internationale Anmeldenummer: PCT/EP2013/056906
(87) Internationale Veröffentlichungsnummer: WO 2013/150007

(56) Entgegenhaltungen:
- WO-A1-2009/012789
- JP-A- H02 264 807
- JP-A- H04 171 415
- US-A1- 2003 007 596
- JAROSZEWICZ, J. ET AL.: "PROGRAMMABLE AXICON FOR VARIABLE INCLINATION OF THE FOCAL SEGMENT", JOURNAL OF MODERN OPTICS, Bd. 51, Nr. 14, 20. September 2004 (2004-09-20), Seiten 2185-2190, XP009175214, DOI: 10.1080/0950034042000265550
- BICKEL, G. ET AL.: "Triangulation with expanded range of depth", OPTICAL ENGINEERING, Bd. 24, Nr. 6, 1. November 1985 (1985-11-01), Seiten 975-977, XP002718024, DOI: 10.1117/12.7973610

## Beschreibung

Die Erfindung betrifft ein Verfahren und eine Vorrichtung mit einer diffraktiven Struktur zur Messung des Abstands zwischen einer Referenzebene und einer Messebene, insbesondere des Abstands zwischen einer Fotomaske und dem Substrat in einer Lithografieanlage, wie z. B. einem Maskenpositionierer (Mask Aligner).

In zahlreichen technischen Anlagen und experimentellen Aufbauten ist es von großer Wichtigkeit, den Abstand von zwei parallelen Ebenen hochgenau zu bestimmen. Insbesondere in einem Maskenpositionierer, einer Vorrichtung der Fotolithografie, spielt diese Messaufgabe eine Schlüsselrolle.

Aus der JP H02 264807 A ist eine Messung eines Abstandes zwischen einer Referenzebene und einer zu der Referenzebene parallelen Messebene bekannt, wobei eine in der Referenzebene angeordnete diffraktive Struktur beleuchtet wird.

Der Erfindung liegt die Aufgabe zugrunde, ein Verfahren anzugeben, das eine berührungslose, hochgenaue Bestimmung des Abstands zwischen zwei parallelen Ebenen ermöglicht. Weiterhin soll eine zur Durchführung des Verfahrens geeignete Vorrichtung angegeben werden.

Diese Aufgaben werden durch ein Verfahren und eine Vorrichtung zur Messung eines Abstands zwischen einer Referenzebene und einer zu der Referenzebene parallelen Messebene gemäß den unabhängigen Patentansprüchen gelöst. Vorteilhafte Ausgestaltungen und Weiterbildungen der Erfindung sind Gegenstand der abhängigen Ansprüche.

Bei dem erfindungsgemäßen Verfahren gemäß Anspruch 1 zur Messung eines Abstands zwischen einer Referenzebene und einer zu der Referenzebene parallelen Messebene wird durch Beleuchtung einer diffraktiven Struktur, die in der Referenzebene angeordnet ist, mindestens ein Axialfokus erzeugt, der gegen eine auf der Referenzebene und der Messebene senkrecht stehende Achse um einen von Null verschiedenen Winkel α geneigt ist.

Die diffraktive Struktur weist vorteilhaft eine spezielle diffraktive Amplituden- und/oder Phasenstruktur auf, die mit kollimiertem Licht beleuchtet wird. Durch die Funktion der diffraktiven Struktur entsteht dabei hinter der Referenzebene mindestens ein Axialfokus, der sich von der Referenzebene aus in Richtung der Messebene erstreckt. Der Axialfokus ist dabei um den Winkel α ≠ 0 gegen die Achse, welche senkrecht auf der Referenz- und Messebene steht, verkippt. Der Neigungswinkel α kann durch das Design der diffraktiven Struktur festgelegt werden.

Im Allgemeinen ist ein Axialfokus durch zwei Charakteristika gekennzeichnet: Lateral, d. h. parallel zur Referenz- und Messebene, ist der Fokus stark begrenzt. Je nach Auslegung der diffraktiven Struktur kann die laterale Ausdehnung des Fokus beispielsweise im Bereich von λ/2 bis einige λ liegen, beispielsweise von λ/2 bis 10 λ, wobei λ die Wellenlänge der verwendeten Beleuchtung ist. Axial, d. h. in seiner Ausbreitungsrichtung, ist der Fokus dagegen weit ausgedehnt. Die Ausdehnung des Axialfokus kann je nach Abmessungen der diffraktiven Struktur von einigen Mikrometern bis hin zu einigen Millimetern reichen, beispielsweise von 1 µm bis 10 mm.

Die axiale Ausdehnung des Axialfokus ist bei dem Verfahren mindestens so groß, dass der sich von der Referenzebene aus ausbreitende Axialfokus mindestens bis zur Messebene reicht. Aufgrund seiner im Vergleich zur lateralen Ausdehnung vergleichsweise großen axialen Ausdehnung, ist der Axialfokus insbesondere nicht punktförmig, sondern erstreckt sich mindestens von der Referenzebene bis zur Messebene. Es ist auch möglich, dass der Axialfokus ähnlich wie ein Lichtstrahl an der Messebene zurück zur Referenzebene reflektiert wird.

Der Abstand d zwischen der Referenzebene und der zu der Referenzebene parallelen Messebene wird bei dem Verfahren aus der Position eines Auftreffpunkts des mindestens einen Axialfokus in der Messebene oder aus der Position eines Auftreffpunkts des an der Messebene reflektierten Axialfokus in der Referenzebene ermittelt.

Die Bestimmung des Abstands d kann beispielsweise dadurch erfolgen, dass ein lateraler Abstand m zwischen dem Auftreffpunkt des Axialfokus in der Messebene und einem Quellpunkt in der Referenzebene ermittelt wird. Der Quellpunkt ist der Punkt in der Referenzebene, von dem aus sich der Axialfokus in Richtung zur Messebene hin ausbreitet. Dieser Quellpunkt wird durch das Design der diffraktiven Struktur bestimmt und kann insbesondere der Mittelpunkt der diffraktiven Struktur sein.

Da der Quellpunkt Q und der Neigungswinkel α des Axialfokus durch die diffraktive Struktur bestimmt und bekannt sind, kann der Abstand d zwischen der Referenzebene und der Messebene durch die Bestimmung des lateralen Abstands m zwischen dem Auftreffpunkt des Axialfokus in der Messebene und dem Quellpunkt Q mittels der Gleichung d = m / tan α bestimmt werden. Diese Gleichung ergibt sich aus den Winkelbeziehungen für rechtwinklige Dreiecke.

Zur Messung des lateralen Abstands m wird bei einer bevorzugten Variante des Verfahrens eine diffraktive Struktur verwendet, welche mindestens zwei Axialfoki erzeugt, und der Abstand d durch die Bestimmung des lateralen Abstands a zwischen den Auftreffpunkten der mindestens zwei Axialfoki in der Messebene ermittelt. Vorzugsweise erzeugt das diffraktive Element zwei symmetrisch geneigte Axialfoki, welche unter den Winkeln α und -α zur Referenzebene verlaufen. In diesem Fall bilden die Axialfoki zusammen mit der Messebene ein gleichschenkliges Dreieck. Durch Messung des Abstands a der Auftreffpunkte der Axialfoki in der Messebene kann über die Relation m = a / 2 der Abstand d zwischen der Referenzebene und der Messebene bestimmt werden.

Bei einer weiteren Ausgestaltung des Verfahrens wird der Abstand d durch Bestimmung eines lateralen Abstands b zwischen einem Auftreffpunkt des an der Messebene reflektierten Axialfokus in der Referenzebene und einem Quellpunkt in der Referenzebene ermittelt. Diese Ausgestaltung des Verfahrens ist insbesondere dann vorteilhaft, wenn eine direkte Messung der Größen a oder m in der Messebene nicht möglich ist. Bei dieser Ausgestaltung ist über die Relation m = b / 2 der Rückschluss auf d möglich.

Bei dieser Ausgestaltung ist es besonders vorteilhaft, wenn die diffraktive Struktur mit einer Skala versehen ist, um den Abstand b zwischen dem Auftreffpunkt des Axialfokus auf der Referenzebene und dem Quellpunkt zu bestimmen. Es ist auch eine Ausgestaltung möglich, bei der der Axialfokus mehrfach an der Messebene reflektiert wird, bevor er den für die Messung vorgesehenen Auftreffpunkt in der Referenzebene erreicht. In diesem Fall ist m = b / 2N, wobei N die Anzahl der Reflexionen ist.

Die Abstände a, b oder m, die zur Bestimmung des Abstands d gemäß den verschiedenen Varianten des Verfahrens bestimmt werden, können fotografisch, fotolithografisch, elektronisch oder optisch bestimmt werden. Beispielsweise kann der Abstand durch Beobachtung mit einem Mikroskop oder mittels eines optoelektronischen Bildsensors bestimmt werden.

Bei einer Variante des Verfahrens wird die Position des Auftreffpunkts des mindestens einen Axialfokus durch Belichtung einer Fotolackschicht und anschließender Entwicklung aufgezeichnet. In diesem Fall erfolgt die Ermittlung des Abstands also fotolithografisch.

Bei einer bevorzugten Ausgestaltung des Verfahrens wird die diffraktive Struktur zur Erzeugung des mindestens einen Axialfokus mit kollimiertem monochromatischem Licht beleuchtet.

Bei einer alternativen Ausgestaltung ist es aber auch möglich, dass die diffraktive Struktur mit kollimiertem Licht verschiedener Wellenlängen beleuchtet wird.

Die Erfindung umfasst auch eine Vorrichtung gemäß Anspruch 9. Die Beleuchtung erzeugt vorteilhaft kollimiertes Licht, insbesondere monochromatisches kollimiertes Licht. Vorteilhafte Ausgestaltungen der Vorrichtung ergeben sich aus der Beschreibung des Verfahrens und umgekehrt.

Bei dem Verfahren und der Vorrichtung wird insbesondere ein zur Referenzebene geneigter Axialfokus für die Abstandsmessung verwendet. Ein Axialfokus ohne Neigung zur Referenzebene, d. h. α = 0°, kann durch ein sogenanntes Axicon erzeugt werden. Dabei handelt es sich um ein optisches Element, welches eine konische Phasenfunktion aufweist. Eine solche Phasenfunktion ist radialsymmetrisch. Sie nimmt ihren Maximalwert in der Symmetrieachse an und fällt nach außen hin linear ab. Bei dem Verfahren und der Vorrichtung gemäß der Erfindung wird das Konzept des Axicons mit einer Lichtablenkung um den Winkel α erweitert.

Um die Ausbreitungsrichtung einer Lichtverteilung zu ändern, kann im Allgemeinen eine diffraktive Struktur mit einer linearen Phasenfunktion genutzt werden. Über die Steigung der Phasenfunktion kann dabei die Stärke der räumlichen Ablenkung festgelegt werden.

Die diffraktive Struktur bei der hierin beschriebenen Vorrichtung weist erfindungsgemäß zur Erzeugung des mindestens einen Axialfokus eine Phasenfunktion auf, die durch Überlagerung einer konischen und einer linearen Phasenfunktion erzeugbar ist. Eine solche Struktur wird hier und im Folgenden als erweitertes Axicon bezeichnet.

Bei der Wahl der Phasenfunktion für das erweiterte Axicon sind zwei Varianten besonders vorteilhaft. Bei einer ersten bevorzugten Variante weisen die konische und die lineare Phasenfunktion die gleiche Steigung auf. Um eine diffraktive Struktur herzustellen, wird die Phasenfunktion in der Regel quantisiert, d. h. in zwei oder mehr diskrete Phasenebenen eingeteilt. Eine solche Quantisierung liefert bei einer konischen Phasenfunktion konzentrische Kreise. Folglich setzt sich ein diffraktives Axicon aus Phasen- und/oder Amplitudenstufen in Form von konzentrischen Kreisen zusammen.

Um die diffraktive Struktur herzustellen, muss die Phasenfunktion auch bei dem erweiterten Axicon quantisiert werden. Diese Quantisierung liefert eine besonders gute Approximation, wenn die Steigung der konischen und der linearen Phasenfunktion gleich gewählt wird. Als Resultat heben sich beide Phasenfunktionen in einer radialen Richtung auf und führen damit auf eine diffraktive Struktur mit besonders vorteilhafter Geometrie.

Bei einer weiteren bevorzugten Variante ist die Phasenfunktion der diffraktiven Struktur senkrecht zu einer Ablenkrichtung gestaucht und in der Ablenkrichtung gestreckt. Dadurch ist es vorteilhaft möglich, Abberation, d. h. Abbildungsfehler, die zu einer Abweichung des Axialfokus von seiner idealen Form führen, zu korrigieren.

Bei einer vorteilhaften Ausgestaltung ist die diffraktive Struktur zur Erzeugung von mindestens zwei Axialfoki, insbesondere von mindestens zwei symmetrischen Axialfoki, geeignet. Um mit einer diffraktiven Struktur mehrere Axialfoki zu erzeugen, werden die zugehörigen Phasenfunktionen der Einzelfoki überlagert. Dies kann zum einen dadurch erfolgen, dass die komplexen Phasenfunktionen der Einzelfoki addiert werden. Zum anderen ist es möglich, dass aus den einzelnen Phasenfunktionen unterschiedliche Bereiche ausgeschnitten und in einer neuen Phasenfunktion zusammengefasst werden.

Bei einer Ausgestaltung ist die diffraktive Struktur eine so genannte quantisierte diffraktive Struktur, die aus abwechselnden transparenten und nicht transparenten Streifen gebildet ist.

In einigen Anwendungen kann es erforderlich sein, die Lichtintensität des mindestens einen Axialfokus, der von der diffraktiven Struktur erzeugt wird, herabzusetzen. Dies wird bei einer vorteilhaften Ausgestaltung dadurch erreicht, dass ein oder mehrere transparente Streifen der diffraktiven Struktur ausgelassen, d.h. durch nicht transparente Streifen ersetzt sind. Die Vorschrift, nach der die transparenten Streifen ausgelassen werden, kann dabei deterministischer oder zufälliger Natur sein.

Die Erfindung wird im Folgenden anhand von Ausführungsbeispielen im Zusammenhang mit den Figuren 1 bis 10 näher erläutert.

Es zeigen:
- Figuren 1 bis 3: jeweils eine schematische Darstellung einer Vorrichtung zur Abstandsmessung gemäß einem Ausführungsbeispiel, und
- Figuren 4 bis 10: jeweils schematische Darstellungen von diffraktiven Strukturen zur Verwendung bei Ausführungsbeispielen des Verfahrens und der Vorrichtung.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

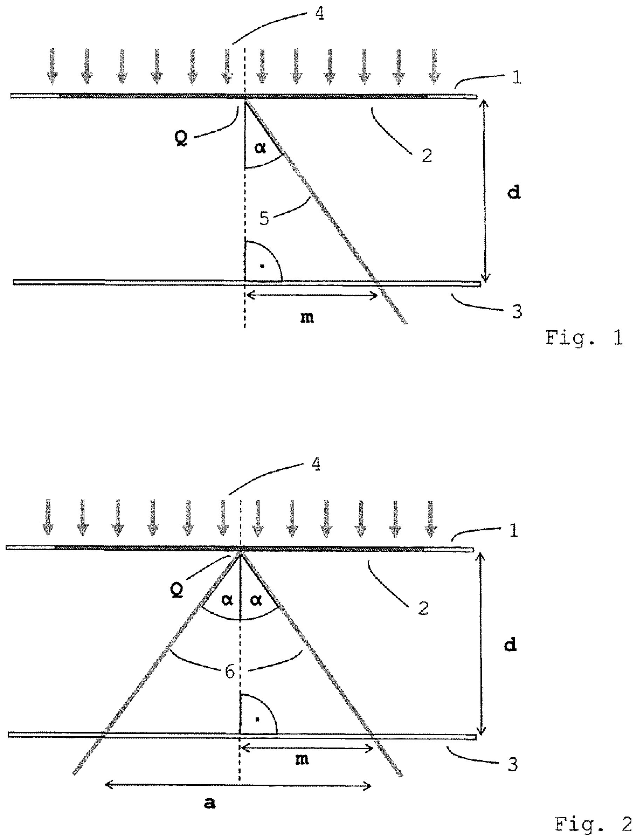

Figur 1 zeigt schematisch einen Querschnitt durch ein Ausführungsbeispiel der Vorrichtung zur Abstandsmessung. Die Vorrichtung weist eine Referenzebene 1 auf, in der die diffraktive Struktur 2 angeordnet ist. In einem Abstand d zur Referenzebene 1 befindet sich eine Messebene 3, deren Abstand d zur Referenzebene 1 mit der Vorrichtung bestimmt werden soll.

Zur Bestimmung des Abstands d wird die diffraktive Struktur 2 vorzugsweise mit kollimiertem monochromatischem Licht 4 beleuchtet. Die diffraktive Struktur 2 ist dazu geeignet, einen Axialfokus 5 zu erzeugen, der um einen Winkel α zu einer auf der Referenzebene 1 und der Messebene 3 senkrecht stehenden Achse geneigt ist. Der Axialfokus 5 ist in seiner Ausdehnung in lateraler Richtung, d. h. parallel zur Referenzebene 1 und Messebene 3, stark begrenzt. Die laterale Ausdehnung kann je nach Auslegung der diffraktiven Struktur etwa λ/2 bis 10 λ betragen, wobei λ die Wellenlänge des Beleuchtungslichts 4 ist. In axialer Richtung, d. h. entlang seiner Ausbreitungsrichtung, ist der Axialfokus 5 weit ausgedehnt und kann beispielsweise eine Ausdehnung von 1 µm bis hin zu 10 mm aufweisen.

Der Axialfokus 5 schneidet die Messebene 3 in einem lateralen Abstand m vom Quellpunkt Q in der Referenzebene 1. Der Quellpunkt Q wird durch das Design der diffraktiven Struktur 2 bestimmt.

Entsprechend der Winkelbeziehungen für rechtwinklige Dreiecke stehen die Größen m, α und d aus Figur 1 in folgendem Zusammenhang: d = m / tan a. Da der Winkel α über das Design der diffraktiven Struktur 2 festgelegt und bekannt ist, lässt sich durch Messung der Größe m der Abstand d zwischen der Referenzebene 1 und der Messebene 3 berechnen.

Im Folgenden werden zwei für die Messung der Größe m besonders vorteilhafte Varianten der Vorrichtung beschrieben. Bei der in Figur 2 dargestellten vorteilhaften Variante der Vorrichtung, die hier und im Folgenden als Konfiguration I bezeichnet wird, wird eine diffraktive Struktur 2 verwendet, welche zwei Axialfoki 6 erzeugt, die symmetrisch um die Winkel α und -α zu einer senkrecht zur Referenzebene 1 und Messebene 3 stehenden Achse geneigt sind. Die Axialfoki 6 bilden dabei zusammen mit der Messebene 3 ein gleichschenkliges Dreieck. Durch Messung des Abstands a der Auftreffpunkte der Axialfoki 6 auf der Messebene 3 kann über die Relation m = a / 2 der Abstand d zwischen der Referenzebene 1 und der Messebene 3 bestimmt werden. Die Bestimmung des Abstands a der Axialfoki 6 kann dabei insbesondere auf fotografischem bzw. fotolithografischem Weg, beispielsweise durch Belichtung von fotoempfindlichem Material, erfolgen. Alternativ kann der Abstand a optoelektronisch, beispielsweise mittels eines Bildsensors, oder optisch, beispielsweise durch Beobachtung mit einem Mikroskop, bestimmt werden.

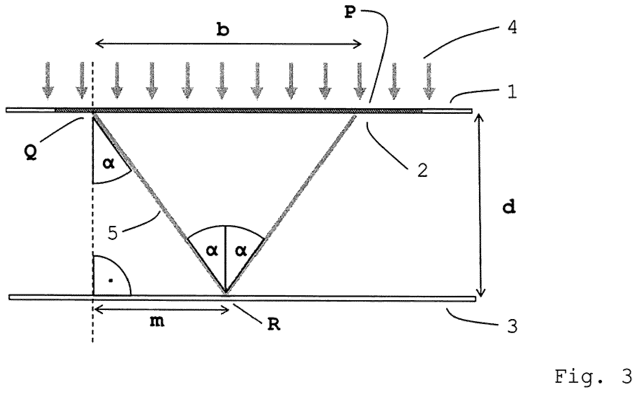

Falls eine direkte Messung der Größen a oder m in der Messebene 3 nicht möglich ist, kann die Messung alternativ in der Referenzebene 1 erfolgen. Ein dazu geeigneter Aufbau der Vorrichtung ist in Figur 3 dargestellt und wird hier und im Folgenden als Konfiguration II bezeichnet. Bei dieser Ausgestaltung der Vorrichtung wird nur ein Axialfokus 5 verwendet und dessen Reflexion im Punkt R an der Messebene 3 genutzt. Nach der Reflexion breitet sich der Axialfokus 5 wieder in Richtung der Referenzebene 1 aus und trifft diese im Punkt P. Wird der Abstand b des Auftreffpunkts P vom Quellpunkt Q gemessen, so ist über die Relation m = b / 2 der Rückschluss auf d möglich. Für die Messung des Abstands b ist es besonders vorteilhaft, die diffraktive Struktur 2 im Bereich des Auftreffpunkts P mit einer zum Quellpunkt Q ortsfesten und kalibrierten Skala zu versehen, an der sich der Abstand b ablesen lässt. Dazu kann die Referenzebene 1 insbesondere von oben mit einem Mikroskop beobachtet werden.

Bei den zuvor beschriebenen Ausführungsbeispielen der Vorrichtung und des Verfahrens wird jeweils mindestens ein Axialfokus 5, 6 verwendet, der um einen von Null verschiedenen Winkel α zu einer auf der Referenzebene 1 senkrecht stehenden Achse geneigt ist. Im Folgenden wird das Design der diffraktiven Struktur 2, die zur Erzeugung eines oder mehrerer geneigter Axialfoki geeignet ist, beschrieben.

Als die diffraktive Struktur 2 zur Erzeugung eines geneigten Axialfokus wird ein erweitertes Axicon verwendet, d.h. eine Phasenstruktur, die durch Überlagerung einer konischen Phasenfunktion mit einer linearen Phasenfunktion gebildet ist.

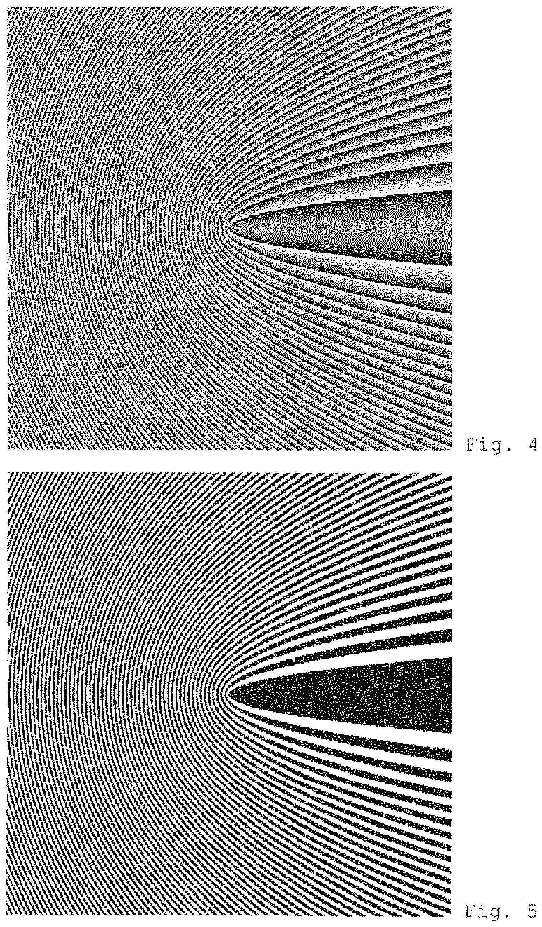

In Figur 4 ist ein Ausführungsbeispiel einer kontinuierlichen Phasenfunktion eines erweiterten Axicons dargestellt, welche einen geneigten Axialfokus erzeugt. Da ein diffraktives Element mit einer derartigen kontinuierlichen Phasenfunktion, die beispielsweise durch eine Grautonabstufung dargestellt werden kann, vergleichsweise schwierig ist, wird die Phasenfunktion vorzugsweise quantisiert, d.h. der kontinuierliche Verlauf der berechneten Phasenfunktion wird durch eine Abfolge von transparenten und nicht transparenten Bereichen approximiert.

Die quantisierte Phasenfunktion des Ausführungsbeispiels der Figur 4 ist in Figur 5 dargestellt. Bei der quantisierten Phasenfunktion der Fig. 5 ist der kontinuierliche Verlauf der berechneten Phasenfunktion der Fig. 4 durch eine Abfolge von transparenten und nicht transparenten Bereichen approximiert. Ein diffraktives Element mit einer derartigen quantisierten Phasenfunktion weist typischerweise abwechselnde transparente und nicht transparente Streifen auf.

Um mit einer diffraktiven Struktur mehrere Axialfoki zu erzeugen, müssen die mindestens zwei Phasenfunktionen der jeweiligen Einzelfoki, wie beispielsweise die Phasenfunktion der Figur 4, überlagert werden. Dies kann auf zwei verschiedene Arten erfolgen.

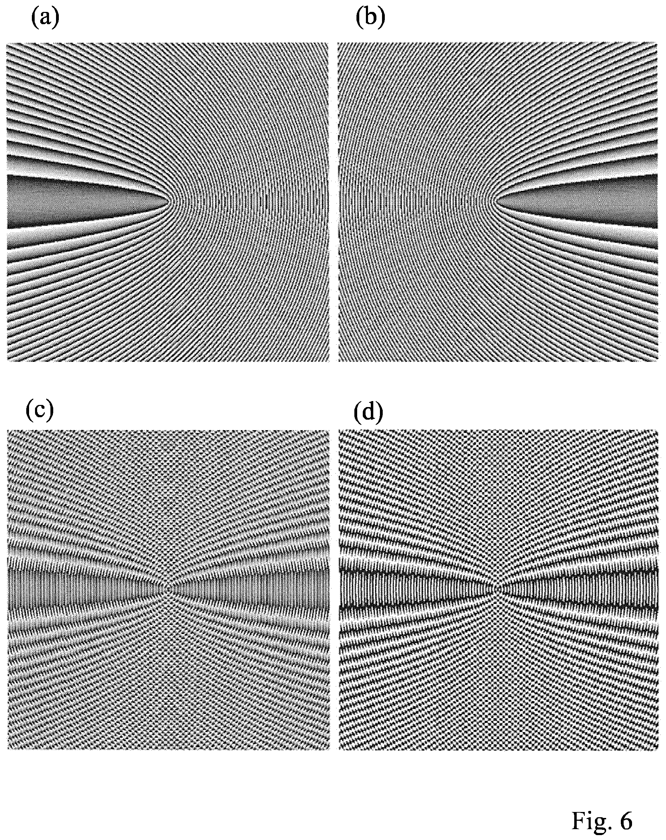

Zum einen ist es möglich, die komplexen Phasenfunktionen der Einzelfoki zu addieren. Beispielsweise zeigt Figur 6 die Phasenfunktion eines ersten Einzelfokus (a), die Phasenfunktion eines zweiten Einzelfokus (b), die Addition der Phasenfunktionen der Einzelfoki (c) sowie die durch Quantisierung der addierten Phasenfunktionen berechnete diffraktive Struktur (d).

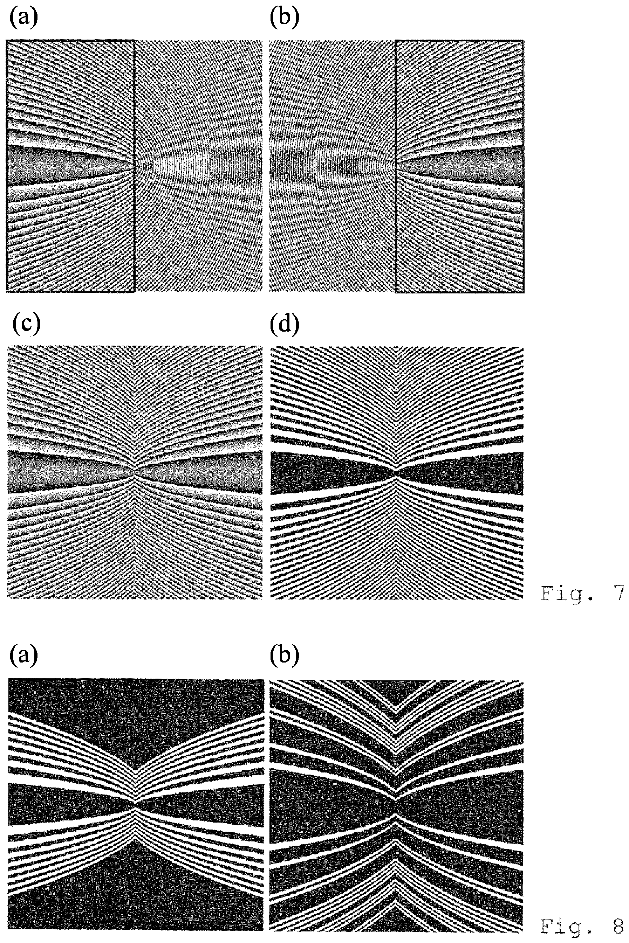

Zum anderen ist es möglich, dass aus den Phasenfunktionen der Einzelfoki jeweils Bereiche ausgeschnitten und in einer neuen Phasenfunktion zusammengefasst werden. Beispielsweise zeigt Figur 7 die Phasenfunktion eines ersten Einzelfokus (a), aus der ein erster Ausschnitt ausgewählt wurde. Weiterhin zeigt Figur 7 die Phasenfunktion eines zweiten Einzelfokus (b), aus der ein weiterer Ausschnitt ausgewählt wurde. Die Addition der Ausschnitte ist in (c) dargestellt. In Figur 7 (d) ist die diffraktive Struktur dargestellt, die sich durch Quantisierung der addierten Phasenfunktionen ergibt.

In einigen Anwendungen kann es erforderlich sein, die Lichtintensität der Axialfoki über die diffraktive Struktur herabzusetzen. Dies ist durch das Auslassen von einzelnen transmittierenden Streifen der diffraktiven Struktur möglich. Die transmittierenden Streifen können in diesem Fall beim Design der diffraktiven Struktur gezielt oder nach dem Zufallsprinzip ausgelassen werden.

Figur 8 zeigt eine solche diffraktive Struktur mit deterministisch (a) und zufällig (b) ausgelassenen transmittierenden Streifen. Die in Figur 8 dargestellte diffraktive Struktur erzeugt beispielsweise zwei symmetrische Axialfoki.

Weiterhin kann es in speziellen Anwendungen erforderlich sein, die diffraktive Struktur mit Licht verschiedener Wellenlängen λᵢ zu beleuchten. In diesem Fall ist es möglich, die Phasenfunktion des erweiterten Axicons für jede beteiligte Wellenlänge λᵢ einzeln zu bestimmen und anschließend alle resultierenden komplexen Phasenfunktionen zu addieren.

Um das messtechnische Problem der Abstandsbestimmung von zwei parallelen Ebenen zu lösen, eignen sich zwei Gestaltungsformen von diffraktiven Strukturen besonders gut. Diese werden im Folgenden beschrieben und sind an die beiden Konfigurationen I und II der Vorrichtung gemäß den Figuren 2 und 3 angepasst.

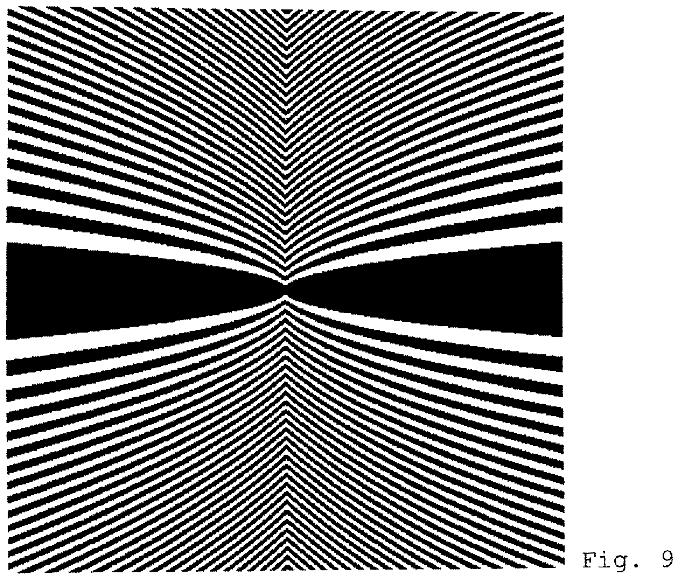

Zur Abstandsmessung nach der in Figur 2 dargestellten Konfiguration I wird vorzugsweise eine diffraktive Struktur verwendet, welche zwei symmetrische geneigte Axialfoki 6 erzeugt. Eine dazu geeignete diffraktive Struktur kann vorteilhaft durch die zuvor anhand von Figur 7 erläuterte Methode, bei der aus den einzelnen Phasenfunktionen unterschiedliche Bereiche ausgeschnitten und in einer neuen Phasenfunktion zusammengefasst werden, erzeugt werden. Ein Beispiel für eine solche Struktur ist in Figur 9 dargestellt.

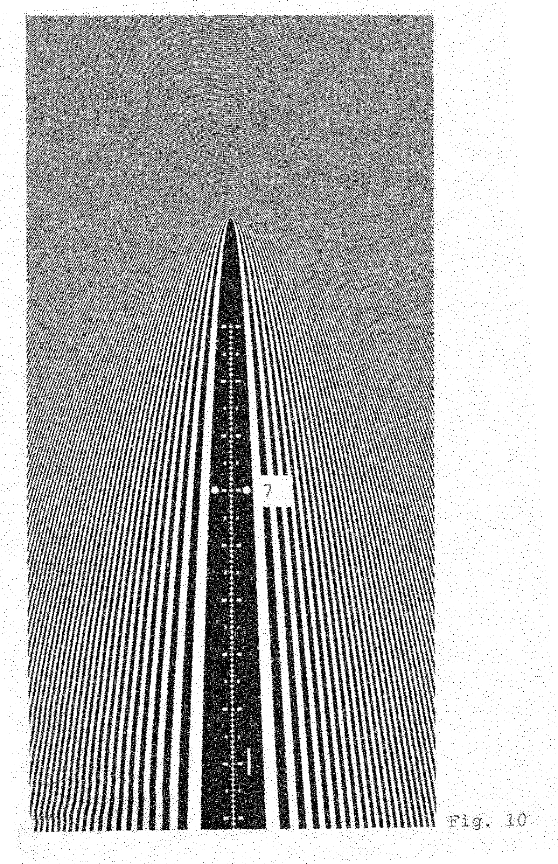

Bei der in Figur 3 dargestellten Vorrichtung zur Abstandsmessung gemäß Konfiguration II wird vorzugsweise eine diffraktive Struktur verwendet, welche genau einen geneigten Axialfokus erzeugt. Dafür eignet sich insbesondere das zuvor beschriebene erweiterte Axicon. Zum Ablesen des Abstands d ist es bei dieser Konfiguration besonders nützlich, die diffraktive Struktur 2 im Bereich P, in welchem der an der Messebene 3 reflektierte Axialfokus 5 auftrifft, mit einer Skala zu versehen. Diese Skala ist vorteilhaft kalibriert und ortsfest zum Quellpunkt Q. Figur 10 zeigt ein Beispiel für eine solche diffraktive Struktur mit zusätzlicher ortsfester und kalibrierter Skala 7.

Die Erfindung ist nicht durch die Beschreibung anhand der Ausführungsbeispiele beschränkt, sondern wird durch die Ansprüche definiert.

## Patentansprüche

1. Verfahren zur Messung eines Abstands (d) zwischen einer Referenzebene (1) und einer zu der Referenzebene (1) parallelen Messebene (3), bei dem
- durch Beleuchtung einer diffraktiven Struktur (2), die in der Referenzebene (1) angeordnet ist, mindestens ein Axialfokus (5) erzeugt wird, der gegen eine auf der Referenzebene (1) und der Messebene (3) senkrecht stehende Achse um einen Winkel α geneigt ist, und
- der Abstand (d) aus der Position eines Auftreffpunkts des mindestens einen Axialfokus (5) in der Messebene (3) oder aus der Position eines Auftreffpunkts des an der Messebene (3) reflektierten Axialfokus (5) in der Referenzebene (1) ermittelt wird,
wobei die diffraktive Struktur (2) zur Erzeugung des mindestens einen Axialfokus (5, 6) eine Phasenfunktion aufweist, die durch Überlagerung einer konischen und einer linearen Phasenfunktion erzeugbar ist.

2. Verfahren nach Anspruch 1,
wobei der Abstand (d) durch Bestimmung eines lateralen Abstands (m) zwischen dem Aufreffpunkt des Axialfokus (5) in der Messebene (3) und einem Quellpunkt (Q) in der Referenzebene (1) ermittelt wird.

3. Verfahren nach Anspruch 1,
wobei mittels der diffraktiven Struktur (2) mindestens zwei Axialfoki (6) erzeugt werden, und der Abstand (d) durch Bestimmung des lateralen Abstands (a) zwischen den Auftreffpunkten der mindestens zwei Axialfoki (6) in der Messebene (3) ermittelt wird.

4. Verfahren nach Anspruch 1,
wobei der Abstand (d) durch Bestimmung eines lateralen Abstands (b) zwischen einem Aufreffpunkt (P) des an der Messebene (3) reflektierten Axialfokus (5) in der Referenzebene (1) und einem Quellpunkt (Q) in der Referenzebene (1) ermittelt wird.

5. Verfahren nach Anspruch 4,
wobei die diffraktive Struktur (2) mit einer Skala (7) versehen ist, um den Abstand (b) zwischen dem Auftreffpunkt (P) des Axialfokus (5) auf der Referenzebene (1) und dem Quellpunkt (Q) zu bestimmen.

6. Verfahren nach einem der vorhergehenden Ansprüche,
wobei die Position des Auftreffpunkts des mindestens einen Axialfokus (5, 6) durch Belichtung einer Fotolackschicht und anschließender Entwicklung aufgezeichnet wird.

7. Verfahren nach einem der vorhergehenden Ansprüche,
wobei die diffraktive Struktur (2) mit kollimiertem monochromatischem Licht (4) beleuchtet wird.

8. Verfahren nach einem der Ansprüche 1 bis 6,
wobei die diffraktive Struktur (2) mit kollimiertem Licht (4) verschiedener Wellenlängen beleuchtet wird.

9. Vorrichtung zur Messung eines Abstands (d) zwischen einer Referenzebene (1) und einer zu der Referenzebene (1) parallelen Messebene (3), umfassend
- eine diffraktive Struktur (2), die in der Referenzebene (1) angeordnet ist, wobei die diffraktive Struktur zur Erzeugung mindestens eines Axialfokus (5) geeignet ist, der gegen eine auf der Referenzebene (1) und der Messebene (3) senkrecht stehende Achse um einen Winkel α geneigt ist, und
- eine Beleuchtung (4),
wobei die diffraktive Struktur (2) zur Erzeugung des mindestens einen Axialfokus (5, 6) eine Phasenfunktion aufweist, die durch Überlagerung einer konischen und einer linearen Phasenfunktion erzeugbar ist.

10. Vorrichtung nach Anspruch 9,
wobei die konische und die lineare Phasenfunktion die gleiche Steigung aufweisen.

11. Vorrichtung nach einem der Ansprüche 9 oder 10,
wobei die diffraktive Struktur (2) zur Erzeugung von mindestens zwei Axialfoki (6) geeignet ist.

12. Vorrichtung nach einem der Ansprüche 9 bis 11,
wobei die diffraktive Struktur (2) eine quantisierte diffraktive Struktur ist, die aus abwechselnden transparenten und nicht transparenten Streifen gebildet ist.

13. Vorrichtung nach Anspruch 12,
wobei ein oder mehrere transparente Streifen der diffraktiven Struktur (2) zur Verminderung der Lichtintensität durch nicht transparente Streifen ersetzt sind.

## Claims

1. A method for measuring a distance (d) between a reference plane (1) and a measurement plane (3) which is parallel to the reference plane (1), in which
- by illuminating a diffractive structure (2) arranged in the reference plane (1), at least one axial focus (5) is generated which is inclined by an angle α against an axis that is perpendicular to the reference plane (1) and the measurement plane (3), and
- the distance (d) is obtained from the position of a point of impingement of the at least one axial focus (5) in the measurement plane (3) or from a position of the point of impingement of the axial focus (3) reflected at the measurement plane (3) in the reference plane (1), wherein the diffractive structure (2), for generating the at least one axial focus (5, 6), comprises a phase function producible by superposing a conical and a linear phase function.

2. The method according to claim 1,
wherein the distance (d) is obtained by determining a lateral distance (m) between the point of impingement of the axial focus (5) in the measurement plane (3) and a source point (Q) in the reference plane (1).

3. The method according to claim 1,
wherein by means of the diffractive structure (2), at least two axial focuses (6) are generated, and the distance (d) is obtained by determining the lateral distance (a) between the points of impingement of the at least two axial focuses (6) in the measurement plane (3).

4. The method according to claim 1,
wherein the distance (d) is obtained by determining a lateral distance (b) between a point of impingement (P) of the axial focus (5) reflected at the measurement plane (3) in the reference plane (1) and a source point (Q) in the reference plane (1).

5. The method according to claim 4,
wherein the diffractive structure (2) is provided with a scale (7) in order to determine the distance (b) between the point of impingement (P) of the axial focus (5) on the reference plane (1) and the source point (Q).

6. The method according to any one of the preceding claims,
wherein the position of the point of impingement of the at least one axial focus (5, 6) is recorded by exposure of a photoresist layer and subsequent development.

7. The method according to any one of the preceding claims,
wherein the diffractive structure (2) is illuminated by collimated monochromatic light (4).

8. The method according to any one of claims 1 to 6,
wherein the diffractive structure (1) is illuminated by collimated light (4) of different wavelengths.

9. A device for measuring a distance (d) between a reference plane (1) and a measurement plane (3) which is parallel to the reference plane (1), comprising
- a diffractive structure (2) arranged in the reference plane (1), wherein the diffractive structure is suitable to generate at least one axial focus (5) inclined by an angle α against an axis that is perpendicular to the reference plane (1) and the measurement plane (3), and
- an illuminating means (4),
- wherein the diffractive structure (2), for generating the at least one axial focus (5, 6), comprises a phase function producible by superposing a conical and a linear phase function.

10. The device according to claim 9,
wherein the conical and the linear phase function have the same gradient.

11. The device according to any one of claims 9 or 10,
wherein the diffractive structure (2) is suitable to generate at least two axial focuses (6).

12. The device according to any one of claims 9 to 11,
wherein the diffractive structure (2) is a quantized diffractive structure formed of alternate transparent and non-transparent strips.

13. The device according to claim 12,
wherein one or more transparent strips of the diffractive structure (2) are replaced by non-transparent strips for reducing the light intensity.

## Revendications

1. Procédé de mesure d'une distance (d) entre un plan de référence (1) et un plan de mesure (3) parallèle au plan de référence (1), dans lequel
- au moins une focale axiale (5) qui est inclinée d'un angle α contre un axe perpendiculaire au plan de référence (1) et au plan de mesure (3) est générée par éclairage d'une structure diffractive (2) qui est disposée dans le plan de référence (1), et
- la distance (d) est déterminée à partir de la position d'un point d'incidence de l'au moins une focale axiale (5) dans le plan de mesure (3) ou à partir de la position d'un point d'incidence de la focale axiale (5) réfléchie sur le plan de mesure (3) dans le plan de référence (1),
sachant que la structure diffractive (2) présente, pour générer l'au moins une focale axiale (5, 6), une fonction de phase qui peut être générée par superposition d'une fonction de phase conique et d'une fonction de phase linéaire.

2. Procédé selon la revendication 1,
sachant que la distance (d) est déterminée par détermination d'une distance latérale (m) entre le point d'incidence de la focale axiale (5) dans le plan de mesure (3) et un point source (Q) dans le plan de référence (1).

3. Procédé selon la revendication 1,
sachant que moyennant la structure diffractive (2), au moins deux focales axiales (6) sont générées, et la distance (d) est déterminée par détermination de la distance latérale (a) entre les points d'incidence des au moins deux focales axiales (6) dans le plan de mesure (3).

4. Procédé selon la revendication 1,
sachant que la distance (d) est déterminée par détermination d'une distance latérale (b) entre un point d'incidence (P) de la focale axiale (5) réfléchie sur le plan de mesure (3) dans le plan de référence (1) et un point source (Q) dans le plan de référence (1).

5. Procédé selon la revendication 4,
sachant que la structure diffractive (2) est pourvue d'une échelle (7) pour déterminer la distance (b) entre le point d'incidence (P) de la focale axiale (5) sur le plan de référence (1) et le point source (Q).

6. Procédé selon l'une des revendications précédentes,
sachant que la position du point d'incidence de l'au moins une focale axiale (5, 6) est enregistrée par exposition d'une couche de vernis photosensible et développement consécutif.

7. Procédé selon l'une des revendications précédentes,
sachant que la structure diffractive (2) est éclairée avec de la lumière (4) monochromatique collimatée.

8. Procédé selon l'une des revendications 1 à 6,
sachant que la structure diffractive (2) est éclairée avec de la lumière (4) collimatée de diverses longueurs d'onde.

9. Procédé de mesure d'une distance (d) entre un plan de référence (1) et un plan de mesure (3) parallèle au plan de référence (1), comprenant
- une structure diffractive (2) qui est disposée dans le plan de référence (1), sachant que la structure diffractive convient pour générer au moins une focale axiale (5) qui est inclinée d'un angle α contre un axe perpendiculaire au plan de référence (1) et au plan de mesure (3), et
- un éclairage (4),
sachant que la structure diffractive (2) présente, pour générer l'au moins une focale axiale (5, 6), une fonction de phase qui peut être générée par superposition d'une fonction de phase conique et d'une fonction de phase linéaire.

10. Procédé selon la revendication 9,
sachant que la fonction de phase conique et la fonction de phase linéaire présentent la même pente.

11. Procédé selon l'une des revendications 9 ou 10,
sachant que la structure diffractive (2) convient pour générer au moins deux focales axiales (6).

12. Procédé selon l'une des revendications 9 à 11,
sachant que la structure diffractive (2) est une structure diffractive quantisée qui est constituée de bandes transparentes et non transparentes alternantes.

13. Procédé selon la revendication 12,
sachant qu'une ou plusieurs bandes transparentes de la structure diffractive (2) sont remplacées par des bandes non transparentes pour diminuer l'intensité lumineuse.
